# EUROPEAN PATENT APPLICATION

(11) **EP 2 487 498 A2**
(43) Date of publication of application: **15.08.2012**
(21) Application number: 10821608.6
(22) Date of filing: 15.09.2010
(51) Int. Cl.: G01R 31/36

(54) **DEVICE FOR DIGITALLY DISPLAYING THE ELECTRIC CHARGE STORED IN ELECTRICITY STORAGE DEVICES**

(30) Priority: 06.10.2009 ES 200930801
(71) Applicant: Viva Developments, S.L., 30800 Lorca (Murcia) (ES)
(72) Inventor: ARENAS DALLA VECCHIA, Aurelio, 30800 Lorca (Murcia) (ES); VICTORIA NAVAS, Leandro, 30800 Lorca (Murcia) (ES); SERRANO PEREZ, Julio Angel, 30800 Lorca (Murcia) (ES)
(74) Representative: Temino Ceniceros, Ignacio
(86) International application number: PCT/ES2010/070600
(87) International publication number: WO 2011/042581

(57) **Abstract**

The invention relates to a device for digitally displaying the electric charge stored in electriticy storage devices. According to the invention, a charge meter (1), a monitor (8) and a monitor controller (6), formed using flexible printed electronics, are incorporated into a flexible plastic support (9), in which the tracks of the corresponding electronic circuits have been printed with conductive ink, said circuits being soldered to the tracks. The resulting device is fitted externally to the wall of the battery, at any visible point thereof, and the output cables of the electronic module measuring the charge level are connected to the battery terminals. The entire assembly is secured and protected by means of external plastic coating.

## Description

### OBJECT OF THE INVENTION

This invention relates to a device for digitally displaying or showing the charge stored in a battery of the type used in automobiles and many other industrial applications such as electrical energy accumulators and capacitors.

The object of this invention is to build a circuit with an electronic format that is flexible, can be attached and fastened to the external surface of the battery and is capable of withstanding harsh environments and mechanically aggressive surroundings such as those found in industrial plants or those present inside automobile engine compartments, without it suffering any alterations.

Thus, the invention is focused on the areas of electricity storage devices, accumulators and capacitors.

### BACKGROUND OF THE INVENTION

Frequently, there is a need to know the electrical charge of a car battery or electricity storage devices in other machinery or systems in order to rule out failure of the device or for checking installation maintenance tasks.

A new trend has emerged for developing user electronic applications known as printed electronics. It involves a new technology that consists in printing electronic circuits on common materials such as paper, plastic and textile media using standard printing equipment that is common in the graphic arts industry.

With this new circuit manufacturing format, electronic systems are created that are more resistant to environmental contamination and mechanical vibrations.

Similar applications exist that are constructed using "conventional" electronics such as the "vumeter", which monitors the electrical charge level stored in a battery by means of lighted bar diagrams (using LEDs). But these systems are operated by means of an additional installation located in a separate location from the battery (for example, inside an automobile).

### DESCRIPTION OF THE INVENTION

The device described in the invention, in particular the "flexible and printed" format version allows for it to be installed on the battery itself at the time the battery is being manufactured, which results in substantial advantages in regards to production costs, ruggedness of the system and simplification of the installation.

Specifically, the device described in the invention allows incorporating a battery charge level indicator attached to the battery casing, and fixed to it using any appropriate means and with an efficient resistance against harsh environments like for example those present inside automobile engine compartments, inside an electrical power generator room, etc.

Specifically, the recommended device is constructed using the functional combination of an electronic module that measures the charge level of the battery, a control module for the segments of the digits of a display, and an alphanumeric display, preferably with 2 + ½ digits to be used as a monitor to display the battery's electrical charge.

These items are integrated in a flexible plastic media and the electronic circuit tracks are printed onto said media using conductive ink.

The module that measures the charge level is directly connected to the battery terminals and depending on the data it receives from the battery it acts upon segments of the display's digits via the control module.

This flexible media, upon which the circuits and the display are installed, is externally laminated in order to seal the assembly and protect it against dust, humidity and other harsh agents.

### DESCRIPTION OF THE DRAWINGS

To complement the description that is being carried out and for the purpose of better understanding the characteristics of the invention, in accordance with a preferred example for carrying it out in a practical way, a set of drawings are provided along with their description, which represent the following in an illustrative but not a limiting fashion:
Figure 1. - Shows an electrical schematic corresponding to the device used for digitally displaying the electrical charge stored in the electricity storage device that is described in this invention.
Figure 2. - Shows the device of the previous figure properly installed on the battery to be checked.

### PREFERRED EMBODIMENT OF THE INVENTION

As shown in the aforementioned figures, the device proposed in the invention is comprised of an electronic module (1) that measures the level of charge in the battery (2); this module is connected to the aforementioned battery (2) terminals (4) using a pair of wires (3).

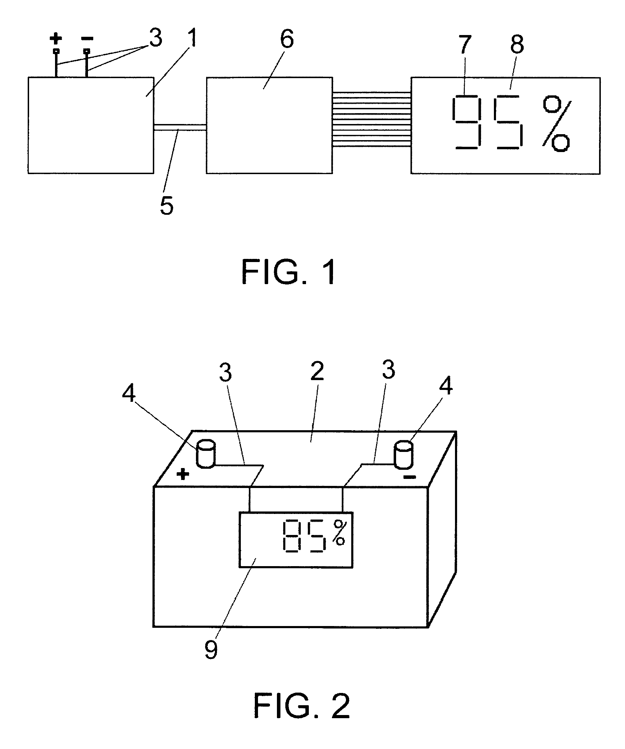

The output (5) of the charge level meter module (1) is connected to a controller (6) for the segments (7) of the digits on a display (8); thus, according to the signal received from the charge meter module (1), said segments (7) corresponding to a display (8) are electrically excited, so that the battery's electrical charge is displayed as a percentage, for example 95% as shown in the example of figure 1, or 85% in that of figure 2.

The three mentioned modules, the charge meter (1), controller (6) and display (8), are installed onto a flexible plastic media (9) as can be seen in figure 2 so that as mentioned before, the electronic circuit tracks are printed onto the aforementioned media (9) using conductive ink, while the integrated circuits that make up the charge module (1) and controller (6) are soldered to said flexible circuit tracks, and the monitor (8) displays are printed, for which purpose electro-chrome displays are used, or any other type of printed display such as OLEDs.

The displays, which are manufactured using electro-chrome technology, operate via the "one touch" method; in other words, they activate when there is a change in their electrical polarization, causing the segments to change colours and remain activated, even though the voltage has previously been removed, until its electrical polarization is again changed. This special feature allows the circuit to remain electrically disconnected without consuming any electrical power, while the latest information is maintained on the displays.

In practice and for manufacturing the device proposed in the invention, first the electrical system on a flexible media is manufactured and subsequently, the media is installed on the battery while the battery is being built.

The manufacturing of the system or electronic module is carried out using "printed electronics" technology in a manner that first, the circuit tracks are built using conductive printing ink and subsequently, the integrated circuits (in "thin film" or "thick film" format) and the pre-fabricated monitor in printed format are installed and soldered. Finally, the flexible card (9) is laminated, leaving two electrical terminal lugs (3) accessible so they can be connected to the battery (2) terminals (4).

The aforementioned card is incorporated during the manufacturing process for the battery, with its conductive wires (3) and the assembly sealed so the circuit is protected and will not become detached, leaving the monitor (8) in a visible location so that it can be monitored by the user.

## Claims

1. ^{st}.- Device for digitally displaying the electrical charge stored in electrical energy storage devices such as for example in automobile electrical energy storage devices or electrical energy storage devices for industrial use, which includes a charge meter, a controller and a display monitor, **characterized in that** said elements are manufactured, at least in part, using printed and flexible electronic technology.

2. ^{nd}.- Device for digitally displaying the electrical charge stored in electricity storage devices according to claim 1, **characterized in that** the electronic module for measuring the charge level is directly connected to the battery terminals, while its output is also connected to the controller of the segments of the digits of the display, exciting some of the segments on said display according to the signals received from the charge meter in order to display the percentage value of the charge on the monitor.

3. ^{rd}.- Device for digitally displaying the electrical charge stored in electricity storage devices according to any preceding claims, **characterized in that** the said components of the device, the electronic module, the controller and the display, are placed on a flexible plastic media, on which the electronic circuit tracks are printed using conductive ink, being the external side of said flexible plastic media and of the elements placed on it laminated with a laminate which acts as protection means and as fastening means.

4. ^{th}. - Device for digitally displaying the electrical charge stored in electricity storage devices according to any preceding claims, **characterized in that** the displays are made of an electrochromic material or any other type of printed material.
